# EUROPEAN PATENT APPLICATION

(11) **EP 4 224 527 A1**
(43) Date of publication of application: **09.08.2023**
(21) Application number: 22746216.5
(22) Date of filing: 26.01.2022
(51) Int. Cl.: H01L 25/13, H01L 33/38, H01L 23/48, H01L 33/54, H01L 33/56, H01L 33/62, G09F 9/302

(54) **LED DISPLAY AND ELECTRONIC APPARATUS COMPRISING SAME**

(30) Priority: 29.01.2021 KR 20210013431
(71) Applicant: Samsung Electronics Co., Ltd., Suwon-si, Gyeonggi-do 16677 (KR)
(72) Inventor: PARK, Taesang, Suwon-si Gyeonggi-do 16677 (KR); KIM, Soohyung, Suwon-si Gyeonggi-do 16677 (KR); HAN, Sangtae, Suwon-si Gyeonggi-do 16677 (KR); AHN, Huigyeong, Suwon-si Gyeonggi-do 16677 (KR); KANG, Changsun, Suwon-si Gyeonggi-do 16677 (KR); LEE, Kyoree, Suwon-si Gyeonggi-do 16677 (KR); JANG, Hyuntae, Suwon-si Gyeonggi-do 16677 (KR); CHOI, Won, Suwon-si Gyeonggi-do 16677 (KR)
(74) Representative: HGF
(86) International application number: PCT/KR2022/001365
(87) International publication number: WO 2022/164189

(57) **Abstract**

In a display device according to various embodiments of the present disclosure, the display device comprises: a printed circuit board (PCB) comprising a display driving circuit; and at least one micro LED package mounted on the display driving circuit, wherein the at least one micro LED package comprises: a flexible printed circuit board comprising a plurality of conductive vias; a plurality of LED devices connected on one surface of the FPCB; at least one connection pad arranged on the rear surface of the FPCB; and a conductive pattern formed on the FPCB to connect the plurality of LED devices and the connection pad through the plurality of conductive vias, and the conductive pattern may commonly connect, to any one of the at least one connection pad, the plurality of LED devices connected to a common signal line from among the plurality of LED devices comprising a plurality of pixels.

## Description

### [Technical Field]

The present disclosure relates to an LED display and an electronic device including the same.

### [Background Art]

Organic light-emitting diode (OLED) displays are in the limelight as a technology to replace liquid crystal displays (LCDs), but high prices, large size, and reliability issues and the like due to low mass production yields remain to be solved.

Recently, micro-LEDs have been attracting attention as a next-generation display technology. A micro-LED is a self-luminescent display element and an ultra-small inorganic light-emitting element which emits light by itself. A micro-LED is capable of emitting red light, green light, and blue light and has a small size, so that one chip is capable of implementing one sub-pixel (one of red, green, and blue). Accordingly, there is no need to use a backlight unit BLU, and higher resolution may be provided.

An LED display may be manufactured by mounting as few as tens of thousands to as many as tens of millions of micro-LEDs on a printed circuit board (PCB) at close intervals. That is, in recent years, in order to output a screen with a higher resolution, research is being conducted in the direction of increasing the number of micro-LED elements mounted on a PCB by reducing the size of pixels including micro-LEDs and the inter-pixel distance (pixel pitch).

### [Disclosure of Invention]

### [Technical Problem]

As the sizes of micro-LEDs have decreased with technological development, the sizes of wiring lines and sizes of via holes for electrically interconnecting the micro-LEDs and a display driving circuit have also been reduced. However, as pixel pitches continue to decrease, controlling the widths and distance of wiring lines and the sizes of via holes that can be manufactured with a PCB has reached a limit, and it is no longer possible to increase the number of micro LEDs that can be mounted on a predetermined area of the PCB.

Various embodiments disclosed herein may provide an LED display equipped with micro-LED packages capable of responding to a decrease in pixel pitch and an electronic device including the LED display.

### [Solution to Problem]

A display device according to various embodiments of the disclosure may include a printed circuit board (PCB) including a display driving circuit, and at least one micro-LED package mounted on the display driving circuit. The at least one micro-LED package may include a flexible printed circuit board (FPCB) including multiple conductive vias, multiple LED elements connected to one surface of the FPCB, one or more connection pads disposed on a rear surface of the FPCB, and a conductive pattern provided on the FPCB to interconnect the multiple LED elements and the connection pad via the multiple conductive vias. The conductive pattern may commonly connect, among the multiple LED elements including multiple pixels, the multiple LED elements connected to a common signal line to one of the one or more connection pads.

A display module according to various embodiments of the disclosure may include a printed circuit board (PCB) including a display driving circuit, and at least one LED package mounted on the display driving circuit. The at least one micro-LED package may include a flexible printed circuit board (FPCB) including multiple conductive vias, multiple LED elements connected to one surface of the FPCB, one or more connection pads disposed on a rear surface of the FPCB, and a conductive pattern provided on the FPCB to interconnect the LED elements and the connection pad via the multiple conductive vias. The conductive pattern may commonly connect, among the multiple LED elements including multiple pixels, at least one LED element connected to a common signal line to one of the one or more connection pads.

### [Advantageous Effects of Invention]

According to various embodiments disclosed herein, even if the number of micro-LEDs mounted on a PCB is increased in response to a decrease in pixel pitch, it is possible to electrically interconnect each micro-LED included in a micro-LED package and a display driving circuit smoothly.

In addition, various effects directly or indirectly identified through this document may be provided.

### [Brief Description of Drawings]

FIG. 1 is an exploded perspective view illustrating a display device according to an embodiment.
FIG. 2 is a view illustrating a structure in which multiple pixels are directly mounted on a PCB according to an embodiment.
FIG. 3 is a view illustrating front and rear surfaces of a micro-LED package according to an embodiment.
FIG. 4 is a cross-sectional view of an LED display module in which micro-LED packages are disposed, according to an embodiment.
FIG. 5 is an enlarged view of a micro-LED package according to an embodiment.
FIG. 6 is a block diagram of an electronic device according to various embodiments in a network environment.

### [Best Mode for Carrying out the Invention]

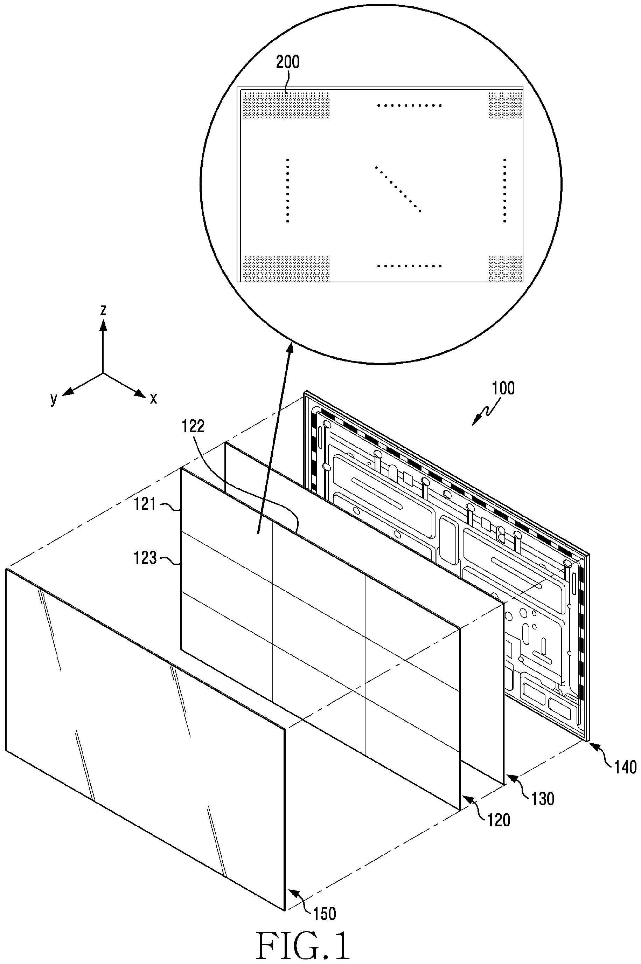

FIG. 1 is an exploded perspective view illustrating a display device 100 according to an embodiment.

The display device 100 described below is a device capable of processing an image signal received from the outside and visually displaying the processed image, and may be implemented in various forms such as a television, a monitor, a portable multimedia device, and a portable communication device without being limited in form as long as it is a device that visually displays an image.

Referring to FIG. 1, the display device 100 may include a protection member 150, multiple LED display modules 120, an arrangement member 130, and a housing 140.

In an embodiment, the protection member 150 may be disposed on the front surface (e.g., in the +y direction) of the display device 100 and may protect the multiple LED display modules 120 disposed on the rear surface (e.g., in the -y direction) from the outside.

In an embodiment, the protection member 150 may be made of a thin glass material, and may be made of various materials as needed.

In an embodiment, the multiple LED display modules 120 may implement light to display an image forward (e.g., in the +y direction) according to an image signal input from the outside.

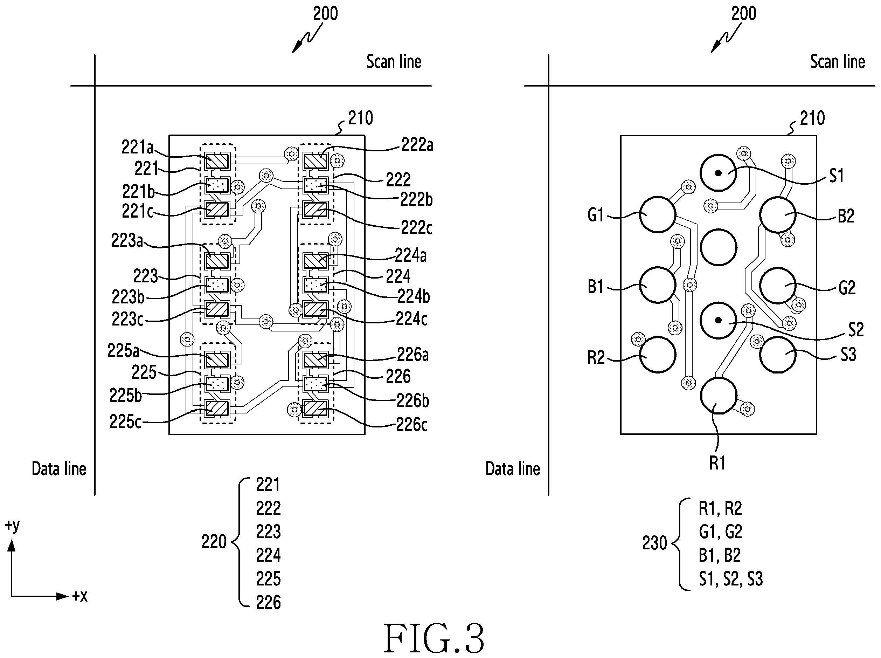

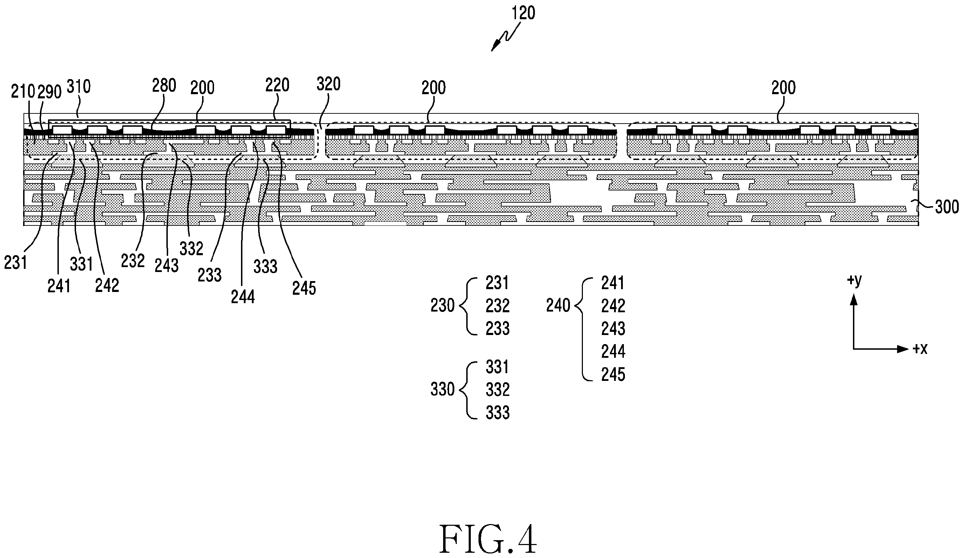

In an embodiment, the multiple LED display modules 120 may include at least one LED package 200. The multiple LED display modules 120 may include a substrate (e.g., a printed circuit board (PCB)) including a display driving circuit (e.g., the PCB 300 in FIG. 4) and multiple pixels 220 (e.g., multiple pixels in FIG. 3). In an example, a pixel may mean an element of minimum unit representing various colors. The multiple pixels 220 may each include multiple micro-LEDs.

In an embodiment, the multiple LED display modules 120 may include multiple gate wiring lines, multiple data lines crossing the multiple wiring lines, and multiple pixels 220 respectively provided in areas where the gate lines GL and the data lines DL intersect.

In an embodiment, multiple micro-LED display modules 120 may be provided.

In an embodiment, the multiple LED display modules 120 may configure a screen of the display device 100 by arranging each LED display module, which is fabricated as a module, according to a display size to be implemented by the LED display module. For example, when a first LED display module 121 and a second LED display module 122 are arranged side by side in the horizontal direction (e.g., the +x-axis direction), the display screen may be implemented longer in the horizontal direction (e.g., the +x-axis direction) than in the vertical (e.g., the +z-axis direction). Display screens in various sizes and shapes may be implemented depending on the number of multiple LED display modules 120 to be arranged and the arrangement form of the multiple LED display modules 120.

In an embodiment, at least one LED package 200 included in the multiple LED display modules 120 will be described in detail with reference to FIGS. 3 to 5.

In an embodiment, the arrangement member 130 may be fabricated as a flat plate and may support the multiple LED display modules 120 such that the multiple LED display modules 120 are arranged in parallel on the same plane. In an example, the arrangement member 130 may implement uniform luminance of the display screen by implementing the same height between the multiple LED display modules 120.

In an embodiment, the housing 140, which defines the exterior of the display device 100, is disposed behind the arrangement member 130 and may stably fix the multiple LED display modules 120 and the arrangement member 130.

In an embodiment, the housing 140 may prevent various components included in the display device 100 from being exposed to the outside and may protect the various components included in the display device 100 from an external impact.

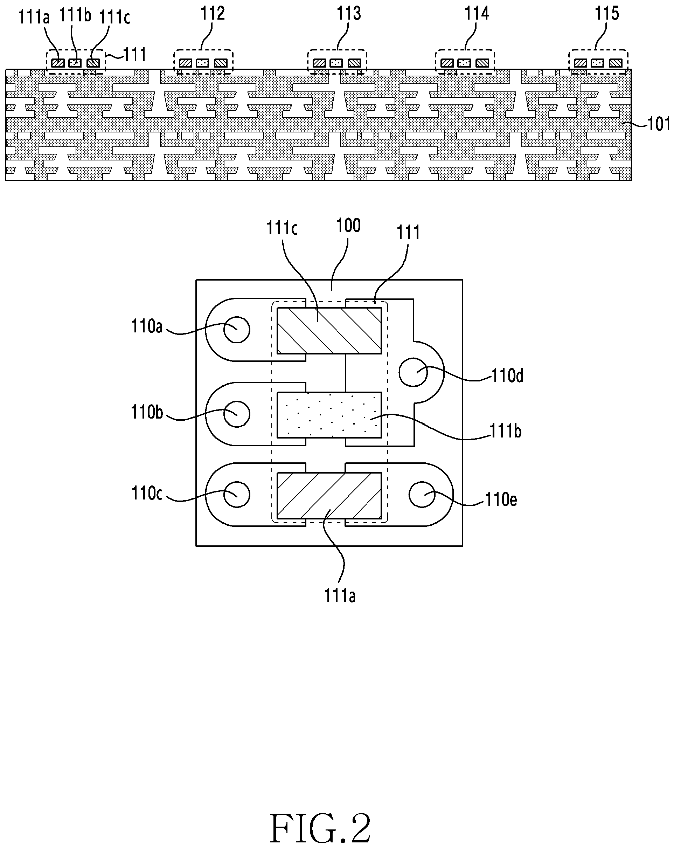

FIG. 2 illustrates a structure in which multiple pixels 110 are directly mounted on a PCB 101 according to an embodiment.

Referring to FIG. 2, the multiple pixels 110 may be directly mounted on the PCB 101. In an example, the multiple pixels 110 may include first to fifth pixels 111 to 115. The first to fifth pixels 111 to 115 may be directly mounted on the PCB 101. The multiple pixels 110 may each include multiple sub-pixels (e.g., a red (R) pixel, a green (G) pixel, and a blue (B) pixel). The sub-pixels may each include a light-emitting diode emitting light of the corresponding color. The light-emitting diode may include a micrometer-sized light-emitting diode (micro-LED). For example, the first pixel 111 may include an LED element 111a emitting red light, an LED element 111b emitting green light, and an LED element 111c emitting blue light. The second to fifth pixels 112 to 115 may have the same configuration as the first pixel 111.

A display driving circuit (not illustrated) may be included in the PCB 101 on which the micro-LEDs are mounted.

When multiple pixels 110 including micro-LEDs are directly mounted on the PCB 101, conductive pads may be required to electrically connect the micro-LEDs to be mounted to the display driving circuit. In an example, conductive pads may be nodes or terminals of the display driving circuit.

When the micro-LEDs are disposed in a predetermined area of the PCB 101, the PCB may include fine wiring lines and via holes that interconnect the micro-LEDs disposed on one surface of the PCB 101 and the conductive pads. In an example, when the micro-LEDs may have a size of about 100 µm or less and the micro-LEDs are arranged in a predetermined unit area of the PCB 101 such that the distance between the micro-LEDs (pixel pitch) corresponds to about 500 µm, it is necessary to implement, in the PCB 101, fine wiring lines having a width of less than 20 µm and via holes having a diameter of about 50 µm or less. However, since there is an aspect ratio between a depth and a diameter required for processing a via hole, it may be difficult to obtain a via having a diameter of about 50 µm through micro-processing in a PCB 101 including the display driving circuit and having a predetermined thickness of about 1 mm or more. In the case of directly mounting micro-LEDs on the PCB 101 including the display driving circuit, the number of micro-LEDs that can be mounted may also be limited because there is a limit to the controllable sizes of the fine wiring lines and the via holes.

In the first pixel 111 mounted on the PCB, an LED element 111c emitting blue light may be electrically connected to the display driving circuit via a first via hole 110a and a fourth via hole 110d. The LED element 111b emitting green light may be electrically connected to the display driving circuit via a second via hole 110b and a fourth via hole 110d. In an example, the LED element 111c emitting blue light and the LED element 111b emitting green light may receive a common electrical signal from the display driving circuit via the fourth via hole 110d. In an example, the LED element 111a emitting red light may be electrically connected to the display driving circuit via a third via hole 110c and a fifth via hole 110e.

The first pixel 111 may be electrically connected to the display driving circuit via at least the first to fifth via holes 110a to 1 10e provided in the PCB 101.

FIG. 3 is a view illustrating front and rear surfaces of a micro-LED package 200 according to an embodiment.

In an embodiment, the micro-LED package 200 may be fabricated in various sizes in consideration of efficiency and yield of a pixel array process. In an example, the micro-LED package 200 may have a 3x2 pixel array structure. The 3x2 pixel array may mean a matrix having 3 rows and 2 columns. In addition, various pixel array structures such as a 1x1 pixel array structure, a 2x2 pixel array structure, and a 4x3 pixel array structure may be included.

In an embodiment, the micro-LED package 200 having the 3x2 pixel array structure may include a first to sixth pixels 221 to 226. In an example, the first pixel 221 may include a blue micro-LED element 221a emitting blue light, a green micro-LED element 221b emitting green light, and a red micro-LED element 221c emitting red light. The second to sixth pixels 222 to 226 may include the same micro-LED devices as the first pixel 221.

In an embodiment, the multiple pixels 220 may be mounted on an FPCB 210. In an example, the FPCB 210 may include polyimide (PI) and/or resin.

In an embodiment, a gate driving circuit (not illustrated) may be disposed on one side (e.g., left or right side) of the pixel array structure of the micro-LED package 200. In an example, a scan line may be controlled via a gate driving circuit. In an example, a data driving circuit (not illustrated) may be disposed on one side (e.g., upper or lower side) of the pixel array structure of the micro-LED package 200. In an example, the data line may be controlled via the data driving circuit.

In an embodiment, an electrode disposed in each of the micro-LED elements included in the multiple pixels 220 may be connected to a wiring line provided in the FPCB 210 to be electrically connected to the display driving circuit. In an example, an electrode disposed in each micro-LED may be electrically connected to a connection pad 230 disposed on the FPCB 210 via a conductive pattern (e.g., the conductive pattern 240 of FIG. 4).

In an embodiment, multiple vias may be provided in the FPCB 210.

In an embodiment, micro-LED elements, which are connected to a common signal line, among the multiple micro-LED elements of the multiple pixels 220, may be commonly connected to one of the connection pads 230. Hereinafter, multiple micro-LED elements having a common signal line will be described.

In an embodiment, micro-LEDs emitting light of the same color in the same column may be connected to at least one connection pad 230 via a common data line. For example, the micro-LED package 200, which has a 3x2 pixel array structure including three rows and two columns, may include, for each column, a first red connection pad R1 connected from the red micro-LED elements 221c, 223c, and 225c to a common wiring line, a second red connection pad R2 connected from the red micro-LED elements 222c, 224c, and 226c to a common wiring line, a first green connection pad G1 connected from the green micro LED elements 221b, 223b, and 225b to a common wiring line, a second green connection pad G2 connected from the green micro LED elements 222b, 224b, and 226b to a common wiring line, a first blue connection pad B1 connected from the blue micro LED elements 221a, 223a, and 225a to a common wiring line, and a second blue connection pad G2 connected from the blue micro LED elements 222a, 224a, and 226a to a common wiring line.

In an embodiment, micro-LEDs in the same row may be connected to at least one connection pad 230 via a common scan line. For example, the micro-LED package 200, which has a 3x2 pixel array structure including three rows and two columns, may include a first pad S1 connected from the first pixel 221 and the second pixel 222 to a common wiring line, a second pad S2 connected from the third pixel 223 and the fourth pixel 224 to a common wiring line, and a third pad S3 connected from the fifth pixel 225 and the six pixel 226 to a common wiring line.

In an embodiment, a micro-LED package 200 having a 3x2 pixel array structure may include a total of nine connection pads R1, R2, G1, G2, B1, B2, S1, S2, and S3. Through the same principle as above, a micro-LED package 200 having a 3X3 pixel array structure may include at least a total of 12 connection pads.

In an embodiment, a micro-LED package 200 may include at least one connection pad 230 to which a common wiring line from the multiple pixels 220 is connected. In an example, the number of connection pads 230 may be reduced by connecting a common signal line to one pad through a rewiring process for wiring lines connected from multiple pixels 220.

FIG. 4 is a cross-sectional view of multiple LED display modules 120 in which at least one micro-LED package 200 is arranged, according to an embodiment.

Referring to FIG. 4, the multiple LED display modules 120 of the display device 100 may include at least one micro-LED package 200. The multiple LED display modules 120 may include multiple micro-LED packages 200 depending on various shapes and sizes thereof.

Referring to FIG. 4, the multiple LED display modules 120 may include at least one micro-LED package 200 and a PCB 300.

In an embodiment, the at least one micro-LED package 200 included in the multiple LED display modules 120 may be protected and fixed by a molding member 320. In an example, an FPCB 210 may be protected and fixed by the molding member 320 to maintain a rigid board shape.

In an embodiment, the multiple LED display modules 120 may include at least one film 310. The at least one film 310 may be disposed on the front surface (e.g., the +y direction) of the at least one micro-LED package 200. In an example, the at least one film 310 may include a low reflection film for minimizing reflection of light emitted from multiple pixels 220.

In an embodiment, the at least one micro-LED package 200 may include an FPCB 210, multiple pixels 220, at least one connection pad 230, and a conductive pattern 240.

In an embodiment, each of the multiple pixels 220 may include a red micro-LED element, a green micro-LED element, and a blue micro-LED element. Each micro-LED element included in the multiple pixels 220 may include an electrode.

In an embodiment, the multiple pixels 220 may be mounted on the FPCB 210. In an example, the FPCB 210 may include a pixel array area. Multiple pixels 220 may be mounted on a portion corresponding to the pixel array area. In an example, the multiple pixels 220 including micro-LED elements may be mounted on the front surface (e.g., the +y direction) of the FPCB 210d via a connection member 290. The connection member 290 may include an anisotropic conductive film (AFC), a non-conductive film, a soldering member, and/or flux. A dye for imparting a black color may be added to the anisotropic conductive film or the non-conductive film.

In an embodiment, the front surface of the FPCB 210 on which the multiple pixels 220 are mounted may include an area on which the multiple pixels 220 are mounted and an area on which the multiple pixels 220 are not mounted. In an example, a side fill 280 may be disposed in the area on which the multiple pixels 220 are not mounted. The side fill 280 may include a material for protecting the multiple pixels 220 and improving image quality. In an example, the side fill 280 may include a liquid resin material. The liquid resin material may include a black dye. Accordingly, the front surface of the FPCB 210 may be seen as black except for the area on which the multiple pixels 220 are disposed.

In an embodiment, a conductive pattern 240 configured to electrically interconnect one or more connection pads 230 and the multiple pixels 220 may be provided on the FPCB 210.

In an embodiment, the connection pads 230 may be included on the rear surface (e.g., the -y direction) of the FPCB 210.

In an embodiment, multiple LED elements, which are connected to a common signal line, among the multiple micro-LED elements of the multiple pixels 220, may be commonly connected to one of the connection pads 230. The common signal line may be connected to one of the connection pads 230 via the conductive pattern 240.

In an embodiment, since the FPCB 210 is a flexible material substrate, precise fine processing is possible compared to a rigid PCB substrate. Accordingly, while it is difficult to fabricate a via hole having a diameter of about 50 µm in a rigid PCB, fine processing may be possible in the FPCB 210.

In an embodiment, a display driver IC (DDI) (not illustrated) may be mounted on the PCB 300. In an example, the PCB 300 may correspond to a driving substrate on which a display driving circuit is mounted.

In an embodiment, the at least one micro-LED package 200 and the PCB 300 may be bonded via multiple soldering members 330. In an example, the multiple soldering members 330 are made of a conductive material and may be used for metal bonding. In an example, the multiple soldering members 330 may be arranged at a predetermined interval between the at least one micro-LED package 200 and the PCB 300. The micro-LED package 200 and the PCB 300 may be electrically connected via a soldering member 330. The micro-LED package 200 may be electrically connected to the display driving circuit mounted on the PCB 300.

In another example, the at least one micro-LED package 200 may be bonded to the PCB via at least one of an anisotropic conductive film (AFC), a non-conductive film, or flux.

In an embodiment, the at least one micro-LED package 200 may have a thickness corresponding to about 50 µm, and the PCB 300 may have a thickness corresponding to about 1.0 mm. As the multiple pixels 220 including micro-LED elements are mounted on the FPCB 210 rather than the PCB 300, it is possible to arrange the multiple pixels 220 according to a configured pixel pitch, and as the multiple pixels 220 are arranged, via holes having various sizes may be provided in the FPCB 210.

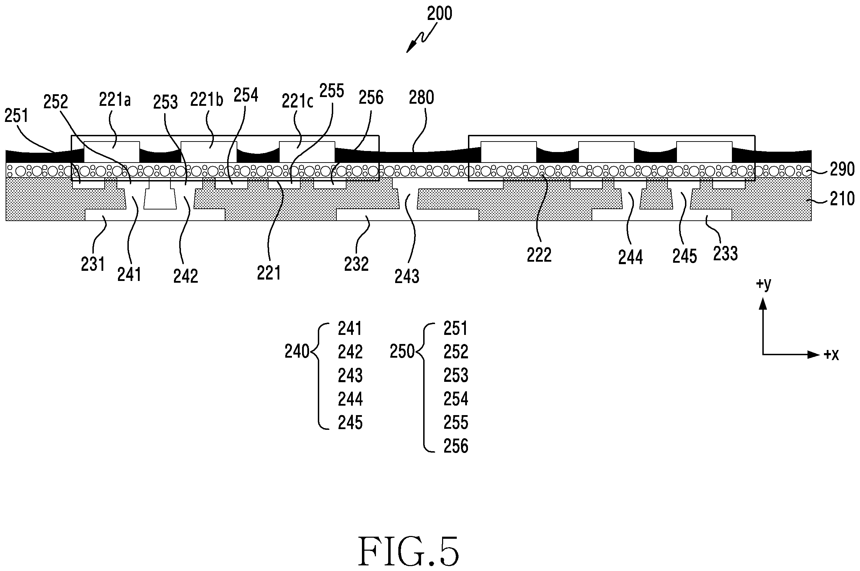

FIG. 5 is an enlarged view of a micro-LED package 200 according to an embodiment.

Referring to FIG. 5, the micro-LED package 200 may include a first pixel 221 and a second pixel 222 among a multiple pixels 220.

In an embodiment, a side fill 280 may be applied to the area where the first pixel 221 and the second pixel 222 are not disposed on the front surface (e.g., the +y direction) of the FPCB 210 through a spraying method (e.g., a jet method). In an example, the side fill 280 may include a liquid resin material.

In an embodiment, the first pixel 221 and the second pixel 222 may be mounted on the FPCB 210 via a connection member 290. In an example, the connection member 290 may include an anisotropic conductive film (AFC), a non-conductive film, and/or flux. In an example, the connection member 290 may include a black dye. In an example, when the black dye is included in the connection member 290, an area other than an area where light is emitted by the first pixel 221 and the second pixel 222 may be seen as a black color.

In an embodiment, the red micro-LED element 221a of the first pixel 221 may include electrodes 251 and 252. The green micro-LED element 221b may include electrodes 253 and 254. The blue micro-LED element 221c may include electrodes 255 and 256. In an example, of the electrodes 251 and 252 of the red micro-LED element 211a, an electrode corresponding to a common electrode may be connected to the first connection pad 231 via a conductive pattern 241. Of the electrodes 253 and 254 of the green micro-LED element 211a, an electrode corresponding to a common electrode may be connected to the first connection pad 231 via a conductive pattern 242.

In an embodiment, among the micro-LED elements included in the multiple pixels 220, LED elements having a common data line or a common gate line may be commonly connected to one of the connection pads 230.

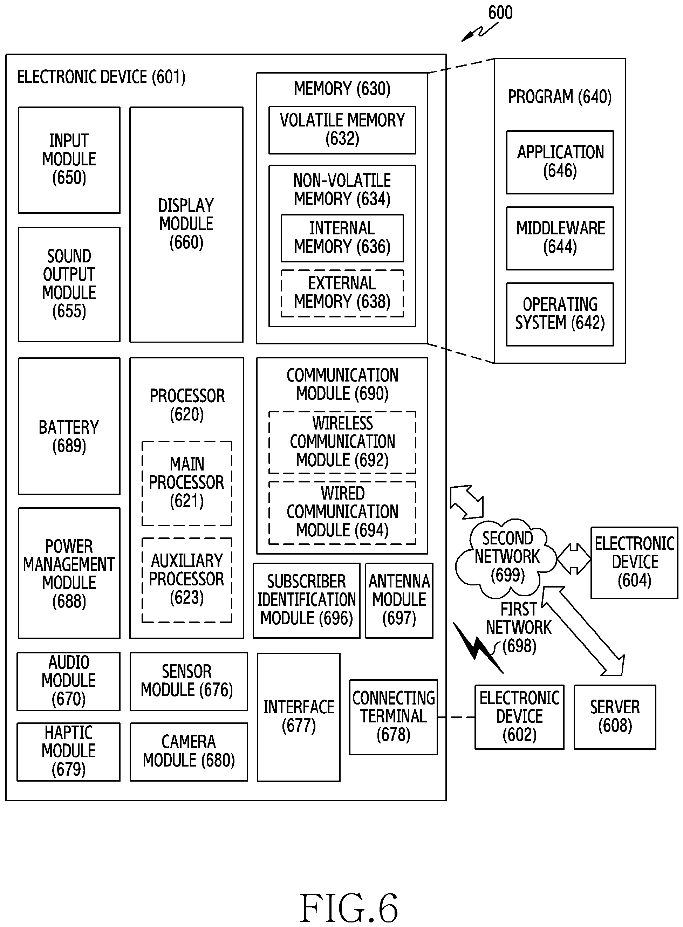

Fig. 6 is a block diagram illustrating an electronic device 601 in a network environment 600 according to various embodiments.

In one embodiment, the electronic device may correspond to the display device of FIG. 1.

Referring to Fig. 6, the electronic device 601 in the network environment 600 may communicate with an electronic device 602 via a first network 698 (e.g., a short-range wireless communication network), or at least one of an electronic device 604 or a server 608 via a second network 699 (e.g., a long-range wireless communication network). According to an embodiment, the electronic device 601 may communicate with the electronic device 604 via the server 608. According to an embodiment, the electronic device 601 may include a processor 620, memory 630, an input module 650, a sound output module 655, a display module 660, an audio module 670, a sensor module 676, an interface 677, a connecting terminal 678, a haptic module 679, a camera module 680, a power management module 688, a battery 689, a communication module 690, a subscriber identification module (SIM) 696, or an antenna module 697. In some embodiments, at least one of the components (e.g., the connecting terminal 678) may be omitted from the electronic device 601, or one or more other components may be added in the electronic device 601. In some embodiments, some of the components (e.g., the sensor module 676, the camera module 680, or the antenna module 697) may be implemented as a single component (e.g., the display module 660).

The processor 620 may execute, for example, software (e.g., a program 640) to control at least one other component (e.g., a hardware or software component) of the electronic device 601 coupled with the processor 620, and may perform various data processing or computation. According to one embodiment, as at least part of the data processing or computation, the processor 620 may store a command or data received from another component (e.g., the sensor module 676 or the communication module 690) in volatile memory 632, process the command or the data stored in the volatile memory 632, and store resulting data in non-volatile memory 634. According to an embodiment, the processor 620 may include a main processor 621 (e.g., a central processing unit (CPU) or an application processor (AP)), or an auxiliary processor 623 (e.g., a graphics processing unit (GPU), a neural processing unit (NPU), an image signal processor (ISP), a sensor hub processor, or a communication processor (CP)) that is operable independently from, or in conjunction with, the main processor 621. For example, when the electronic device 601 includes the main processor 621 and the auxiliary processor 623, the auxiliary processor 623 may be adapted to consume less power than the main processor 621, or to be specific to a specified function. The auxiliary processor 623 may be implemented as separate from, or as part of the main processor 621.

The auxiliary processor 623 may control at least some of functions or states related to at least one component (e.g., the display module 660, the sensor module 676, or the communication module 690) among the components of the electronic device 601, instead of the main processor 621 while the main processor 621 is in an inactive (e.g., sleep) state, or together with the main processor 621 while the main processor 621 is in an active state (e.g., executing an application). According to an embodiment, the auxiliary processor 623 (e.g., an image signal processor or a communication processor) may be implemented as part of another component (e.g., the camera module 680 or the communication module 690) functionally related to the auxiliary processor 623. According to an embodiment, the auxiliary processor 623 (e.g., the neural processing unit) may include a hardware structure specified for artificial intelligence model processing. An artificial intelligence model may be generated by machine learning. Such learning may be performed, e.g., by the electronic device 601 where the artificial intelligence is performed or via a separate server (e.g., the server 608). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 630 may store various data used by at least one component (e.g., the processor 620 or the sensor module 676) of the electronic device 601. The various data may include, for example, software (e.g., the program 640) and input data or output data for a command related thererto. The memory 630 may include the volatile memory 632 or the non-volatile memory 634.

The program 640 may be stored in the memory 630 as software, and may include, for example, an operating system (OS) 642, middleware 644, or an application 646.

The input module 650 may receive a command or data to be used by another component (e.g., the processor 620) of the electronic device 601, from the outside (e.g., a user) of the electronic device 601. The input module 650 may include, for example, a microphone, a mouse, a keyboard, a key (e.g., a button), or a digital pen (e.g., a stylus pen).

The sound output module 655 may output sound signals to the outside of the electronic device 601. The sound output module 655 may include, for example, a speaker or a receiver. The speaker may be used for general purposes, such as playing multimedia or playing recordings. The receiver may be used for receiving incoming calls. According to an embodiment, the receiver may be implemented as separate from, or as part of the speaker.

The display module 660 may visually provide information to the outside (e.g., a user) of the electronic device 601. The display module 660 may include, for example, a display, a hologram device, or a projector and control circuitry to control a corresponding one of the display, hologram device, and projector. According to an embodiment, the display module 660 may include a touch sensor adapted to detect a touch, or a pressure sensor adapted to measure the intensity of force incurred by the touch.

The audio module 670 may convert a sound into an electrical signal and vice versa. According to an embodiment, the audio module 670 may obtain the sound via the input module 650, or output the sound via the sound output module 655 or a headphone of an external electronic device (e.g., an electronic device 602) directly (e.g., wiredly) or wirelessly coupled with the electronic device 601.

The sensor module 676 may detect an operational state (e.g., power or temperature) of the electronic device 601 or an environmental state (e.g., a state of a user) external to the electronic device 601, and then generate an electrical signal or data value corresponding to the detected state. According to an embodiment, the sensor module 676 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 677 may support one or more specified protocols to be used for the electronic device 601 to be coupled with the external electronic device (e.g., the electronic device 602) directly (e.g., wiredly) or wirelessly. According to an embodiment, the interface 677 may include, for example, a high definition multimedia interface (HDMI), a universal serial bus (USB) interface, a secure digital (SD) card interface, or an audio interface.

A connecting terminal 678 may include a connector via which the electronic device 601 may be physically connected with the external electronic device (e.g., the electronic device 602). According to an embodiment, the connecting terminal 678 may include, for example, a HDMI connector, a USB connector, a SD card connector, or an audio connector (e.g., a headphone connector).

The haptic module 679 may convert an electrical signal into a mechanical stimulus (e.g., a vibration or a movement) or electrical stimulus which may be recognized by a user via his tactile sensation or kinesthetic sensation. According to an embodiment, the haptic module 679 may include, for example, a motor, a piezoelectric element, or an electric stimulator.

The camera module 680 may capture a still image or moving images. According to an embodiment, the camera module 680 may include one or more lenses, image sensors, image signal processors, or flashes.

The power management module 688 may manage power supplied to the electronic device 601. According to one embodiment, the power management module 688 may be implemented as at least part of, for example, a power management integrated circuit (PMIC).

The battery 689 may supply power to at least one component of the electronic device 601. According to an embodiment, the battery 689 may include, for example, a primary cell which is not rechargeable, a secondary cell which is rechargeable, or a fuel cell.

The communication module 690 may support establishing a direct (e.g., wired) communication channel or a wireless communication channel between the electronic device 601 and the external electronic device (e.g., the electronic device 602, the electronic device 604, or the server 608) and performing communication via the established communication channel. The communication module 690 may include one or more communication processors that are operable independently from the processor 620 (e.g., the application processor (AP)) and supports a direct (e.g., wired) communication or a wireless communication. According to an embodiment, the communication module 690 may include a wireless communication module 692 (e.g., a cellular communication module, a short-range wireless communication module, or a global navigation satellite system (GNSS) communication module) or a wired communication module 694 (e.g., a local area network (LAN) communication module or a power line communication (PLC) module). A corresponding one of these communication modules may communicate with the external electronic device via the first network 698 (e.g., a short-range communication network, such as Bluetooth^{™}, wireless-fidelity (Wi-Fi) direct, or infrared data association (IrDA)) or the second network 699 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 692 may identify and authenticate the electronic device 601 in a communication network, such as the first network 698 or the second network 699, using subscriber information (e.g., international mobile subscriber identity (IMSI)) stored in the subscriber identification module 696.

The wireless communication module 692 may support a 5G network, after a 4G network, and next-generation communication technology, e.g., new radio (NR) access technology. The NR access technology may support enhanced mobile broadband (eMBB), massive machine type communications (mMTC), or ultrareliable and low-latency communications (URLLC). The wireless communication module 692 may support a high-frequency band (e.g., the mmWave band) to achieve, e.g., a high data transmission rate. The wireless communication module 692 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 692 may support various requirements specified in the electronic device 601, an external electronic device (e.g., the electronic device 604), or a network system (e.g., the second network 699). According to an embodiment, the wireless communication module 692 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (LTL), or a round trip of 1ms or less) for implementing URLLC.

The antenna module 697 may transmit or receive a signal or power to or from the outside (e.g., the external electronic device) of the electronic device 601. According to an embodiment, the antenna module 697 may include an antenna including a radiating element composed of a conductive material or a conductive pattern formed in or on a substrate (e.g., a printed circuit board (PCB)). According to an embodiment, the antenna module 697 may include a plurality of antennas (e.g., array antennas). In such a case, at least one antenna appropriate for a communication scheme used in the communication network, such as the first network 698 or the second network 699, may be selected, for example, by the communication module 690 (e.g., the wireless communication module 692) from the plurality of antennas. The signal or the power may then be transmitted or received between the communication module 690 and the external electronic device via the selected at least one antenna. According to an embodiment, another component (e.g., a radio frequency integrated circuit (RFIC)) other than the radiating element may be additionally formed as part of the antenna module 697.

According to various embodiments, the antenna module 697 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an interperipheral communication scheme (e.g., a bus, general purpose input and output (GPIO), serial peripheral interface (SPI), or mobile industry processor interface (MIPI)).

According to an embodiment, commands or data may be transmitted or received between the electronic device 601 and the external electronic device 604 via the server 608 coupled with the second network 699. Each of the electronic devices 602 or 604 may be a device of a same type as, or a different type, from the electronic device 601. According to an embodiment, all or some of operations to be executed at the electronic device 601 may be executed at one or more of the external electronic devices 602, 604, or 608. For example, if the electronic device 601 should perform a function or a service automatically, or in response to a request from a user or another device, the electronic device 601, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 601. The electronic device 601 may provide the outcome, with or without further processing of the outcome, as at least part of a reply to the request. To that end, a cloud computing, distributed computing, mobile edge computing (MEC), or client-server computing technology may be used, for example. The electronic device 601 may provide ultralow latency services using, e.g., distributed computing or mobile edge computing. In another embodiment, the external electronic device 604 may include an internet-ofthings (IoT) device. The server 608 may be an intelligent server using machine learning and/or a neural network. According to an embodiment, the external electronic device 604 or the server 608 may be included in the second network 699. The electronic device 601 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an applicationspecific integrated circuit (ASIC).

Various embodiments as set forth herein may be implemented as software (e.g., the program 640) including one or more instructions that are stored in a storage medium (e.g., internal memory 636 or external memory 638) that is readable by a machine (e.g., the electronic device 601). For example, a processor (e.g., the processor 620) of the machine (e.g., the electronic device 601) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

A display device according to various embodiments may include a printed circuit board (PCB) including a display driving circuit, and at least one micro-LED package mounted on the display driving circuit. The at least one micro-LED package may include a flexible printed circuit board (FPCB) including multiple conductive vias, multiple LED elements connected to one surface of the FPCB, one or more connection pads disposed on a rear surface of the FPCB, and a conductive pattern provided on the FPCB to interconnect the multiple LED elements and the connection pad via the multiple conductive vias. The conductive pattern may commonly connect, among the multiple LED elements including multiple pixels, the multiple LED elements connected to a common signal line to one of the one or more connection pads.

According to an embodiment, the FPCB may include polyimide (PI).

According to an embodiment, the at least one micro-LED package may further include a side fill disposed in a separation space between the multiple LED elements.

According to an embodiment, the side fill may include a liquid resin material.

According to an embodiment, the multiple micro-LED devices may be mounted on one surface of the FPCB via a connection member.

According to an embodiment, the connection member may include at least one of an anisotropic conductive film (AFC), a non-conductive film, solder, or flux.

According to an embodiment, the multiple LED elements may include at least one of a red micro-LED configured to emit red light, a green micro-LED configured to emit green light, and a blue micro-LED configured to emit blue light.

According to an embodiment, the common signal line may include at least one of a signal line input to a same data line or a signal line input to a same scan line.

According to an embodiment, the PCB and the at least one micro-LED package may be electrically connected to each other via a soldering member.

According to an embodiment, the display device may further include a molding member configured to connect and protect the at least one micro-LED package.

A display module according to various embodiments may include a printed circuit board (PCB) including a display driving circuit, and at least one micro-LED package mounted on the display driving circuit. The at least one micro-LED package may include a flexible printed circuit board (FPCB) including multiple conductive vias, multiple LED elements connected to one surface of the FPCB, one or more connection pads disposed on a rear surface of the FPCB, and a conductive pattern provided on the FPCB to interconnect the LED elements and the connection pad via the multiple conductive vias. The conductive pattern may commonly connect, among the multiple LED elements including multiple pixels, at least one LED element connected to a common signal line to one of the one or more connection pads.

According to an embodiment, the multiple LED elements may include at least one of a red micro-LED configured to emit red light, a green micro-LED configured to emit green light, and a blue micro-LED configured to emit blue light.

According to an embodiment, the common signal line may include at least one of a signal line input to a same data line or a signal line input to a same scan line.

According to an embodiment, the PCB and the at least one micro-LED package may be electrically connected to each other via a soldering member.

According to an embodiment, the display module may further include a molding member configured to connect and protect the at least one micro-LED package.

## Claims

1. A display device comprising:
a printed circuit board (PCB) comprising a display driving circuit; and
at least one micro-LED package mounted on the display driving circuit,
wherein the at least one micro-LED package comprises:
a flexible printed circuit board (FPCB) comprising multiple conductive vias;
multiple LED elements connected on one surface of the FPCB;
one or more connection pads disposed on a rear surface of the FPCB; and
a conductive pattern provided on the FPCB to interconnect the multiple LED elements and the connection pad via the multiple conductive vias, wherein the conductive pattern commonly connects, among the multiple LED elements comprising multiple pixels, the multiple LED elements connected to a common signal line to one of the one or more connection pads.

2. The display device of claim 1, wherein the FPCB comprises polyimide (PI).

3. The display device of claim 1, wherein the at least one micro-LED package further comprises a side fill disposed in a separation space between the multiple LED elements.

4. The display device of claim 3, wherein the side fill comprises a liquid resin material.

5. The display device of claim 1, wherein the multiple micro-LED devices are mounted on one surface of the FPCB via a connection member.

6. The display device of claim 5, wherein the connection member comprises at least one of an anisotropic conductive film (AFC), a non-conductive film, a soldering member, or flux.

7. The display device of claim 1, wherein the multiple LED elements comprise at least one of a red micro-LED configured to emit red light, a green micro-LED configured to emit green light, and a blue micro-LED configured to emit blue light.

8. The display device of claim 1, wherein the common signal line comprises at least one of a signal line input to a same data line or a signal line input to a same scan line.

9. The display device of claim 1, wherein the PCB and the at least one micro-LED package are electrically connected to each other via a soldering member.

10. The display device of claim 1, further comprising a molding member configured to connect and protect the at least one micro-LED package.

11. A display module comprising:
a printed circuit board (PCB) comprising a display driving circuit; and
at least one micro-LED package mounted on the display driving circuit,
wherein the at least one micro-LED package comprises:
a flexible printed circuit board (FPCB) comprising multiple conductive vias;
multiple LED elements connected to one surface of the FPCB;
one or more connection pads disposed on a rear surface of the FPCB; and
a conductive pattern provided on the FPCB to interconnect the LED elements and the connection pad via the multiple conductive vias, wherein the conductive pattern commonly connects, among the multiple LED elements comprising multiple pixels, at least one LED element connected to a common signal line to one of the one or more connection pads.

12. The camera module of claim 11, wherein the multiple LED elements comprise at least one of a red micro-LED configured to emit red light, a green micro-LED configured to emit green light, and a blue micro-LED configured to emit blue light.

13. The display module of claim 11, wherein the common signal line comprises at least one of a signal line input to a same data line or a signal line input to a same scan line.

14. The display module of claim 11, wherein the PCB and the at least one micro-LED package are electrically connected via a soldering member.

15. The display module of claim 11, further comprising a molding member configured to connect and protect the at least one micro-LED package.
